# EUROPEAN PATENT SPECIFICATION

(11) **EP 2 451 068 B1**
(45) Date of publication and mention of the grant of the patent: **11.03.2020**
(21) Application number: 11158797.8
(22) Date of filing: 18.03.2011
(51) Int. Cl.: H02M 7/00

(54) **Motor drive device**
Motorantriebsvorrichtung
Dispositif de commande de moteur

(30) Priority: 05.11.2010 JP 2010248552
(43) Date of publication of application: 09.05.2012
(73) Proprietor: Mitsubishi Electric Corporation, Chiyoda-ku Tokyo 100-8310 (JP)
(72) Inventor: Tanaka, Daisuke, Tokyo 100-8310 (JP); Omae, Katsuhiko, Tokyo 100-8310 (JP); Asao, Yoshihito, Tokyo 100-8310 (JP)
(74) Representative: Hoffmann Eitle

(56) References cited:
- EP-A2- 1 650 859
- US-A1- 2006 126 253
- ZAMBRANO R ED - INSTITUTION OF ELECTRICAL ENGINEERS: "IMPROVED STRUCTURES FOR POWER MOSFETS WITH ON-CHIP FULL PROTECTION", MATERIALS AND DEVICES. BRIGHTON, SEPT. 13 - 16, 1993; [PROCEEDINGS OF THE EUROPEAN CONFERENCE ON POWER ELECTRONICS AND APPLICATIONS], LONDON, IEE, GB, vol. 2, 13 September 1993 (1993-09-13), pages 1-04, XP000416030,
- ROBB S P ET AL: "Industry trends in power integrated circuits", 19881211; 19881211 - 19881214, 11 December 1988 (1988-12-11), pages 792-795, XP010070769,

## Description

### BACKGROUND OF THE INVENTION

### Field of the invention

The present invention relates to a motor drive device that drives a motor in a controlled manner by a motor drive circuit configured with a bridge connection of switching transistors.

### Description of the related art

In some of conventional motor drive devices, resisters each are disposed and connected between the gate and source of switching transistors, such as FETs (field effect transistors) or bipolar transistors (between the base and emitter in the case of bipolar transistors), used for a motor drive circuit, whereby when its drive signal path comes into a high-impedance or open state, gate charge is discharged and gate voltage is decreased to lower than a threshold voltage at which the transistors turn off. (Refer to, for example, Patent Document 1.)

Moreover, although there has been no description of a conventional example, when an open-circuit failure occurs in a drive signal path and pulses arise at the drain side of a transistor due to switching operation of another transistor, in order to prevent the transistor from turning on by the pulses superimposed on the gate side thereof through the parasitic capacitance between the gate and drain of the transistor, it is conceivable to dispose and connect a capacitor between the gate and source, for the purpose of capacitively dividing the pulse voltage by the capacitance between the gate and drain and that of the capacitor between gate and source so as to decrease the voltage superimposed on the gate to lower than the threshold voltage.

Patent Document 1: Japanese Patent No. 2819878 (FIG. 1 and FIG. 4)

In the motor drive circuit of the conventional motor drive device described above, when an open-circuit failure or an impedance change equivalent to the open-circuit failure occurs in a path from a transistor drive circuit for generating a drive signal, to the transistor, if the failure location is closer to the gate of the transistor than the resistor between gate and source, the resistor between gate and source also comes into the open state, so that its function of turning off the transistor will be negated.

This is the same with the capacitor between gate and source, that is, if the failure location is closer to the transistor gate than the capacitor junction point, its function of turning off the transistor is negated, thereby causing a problem in that a short-circuit current arises, which may lead to breakdown of the transistor. In particular, since wiring in the conventional structure includes a wiring pattern on a metal or glass-epoxy substrate, the open-circuit failure is likely to occur as deterioration by heat progresses, which has been a serious problem.

Moreover, US 2006/0126253 A1 describes an inverter circuit configured with main circuit switches SwH, SwL each having a control terminal and first and second main terminals through which the main current flows, and driving circuits each of which applies the driving voltage to the control terminal of each main circuit switch, and controls the main current in accordance with the voltage between the control terminal and the first main terminal, to switch the main circuit switch, between the main circuit switch and the driving circuit, noise-suppression circuits are provided, each of which is configured so as to detect fluctuations in the voltage between the first and the second main terminals of each main circuit switch, and, in accordance with the amplitude and the frequency of the detected voltage fluctuations, to bring to approximately zero the impedance across the control terminal and the first main terminal of each main circuit switch.

### SUMMARY OF THE INVENTION

The present invention has been made to solve the problems described above, which aims at providing a motor drive device in which even when an open-circuit failure occurs in a drive signal path inside the motor drive device, the device does not fall into a dangerous situation such as switching transistors turning on, causing a short-circuit current and transistor breakdown, so that the transistors of the motor drive circuit can be brought into a safe off-state.

A motor drive device according to the present invention comprises: a motor drive circuit that includes switching transistors connected in a bridge configuration and to which are connected a motor drive power supply between the input terminals thereof and a motor between the output terminals thereof; and a transistor drive circuit that supplies a drive signal to the switching transistors of the motor drive circuit and takes on/off control of the switching transistors; wherein resisters are connected between the gate and source (or the base and emitter) of each of the switching transistors of the motor drive circuit so as to turn off the switching transistors when an open-circuit failure occurs in a drive signal path from the transistor drive circuit to the switching transistors, and the resisters for bringing the respective switching transistors into off-state are disposed inside the respective switching transistors.

Moreover, a motor drive device according to the invention comprises: a motor drive circuit that includes switching transistors connected in a bridge configuration and to which are connected a motor drive power supply between the input terminals thereof and a motor between the output terminals thereof; and a transistor drive circuit that supplies a drive signal to the transistors of the motor drive circuit and takes on/off control of the switching transistors; wherein capacitors are connected between the gate and source (or the base and emitter) of each of the switching transistors of the motor drive circuit so as to turn off the switching transistors when an open-circuit failure occurs in a drive signal path from the transistor drive circuit to the switching transistors, and the capacitors for bringing the respective switching transistors into off-state are disposed inside the respective switching transistors.

According to the present invention, a motor drive device can be provided in which even when an open-circuit failure occurs in a drive signal path in the motor drive device, the device does not fall into a dangerous situation such as the switching transistors turning on, causing a short-circuit current and transistor breakdown, so that the transistors of the motor drive circuit can be safely brought into the off-state without fail.

The foregoing and other object, features, aspects and advantages of the present invention will become more apparent from the following detailed description of the present invention when taken in conjunction with the accompanying drawings.

### BRIEF DESCRIPTION OF THE DRAWINGS

FIG. 1 is a circuit configuration diagram of a motor drive device according to Embodiment 1 of the present invention;
FIG. 2 is a configuration diagram of a transistor according to Embodiment 1 of the invention;
FIG. 3 is a circuit configuration diagram of a motor drive device according to Embodiment 2 of the invention;
FIG. 4 is a voltage waveform diagram for supplementarily explaining operation details according to Embodiment 2 of the invention; and
FIG. 5 is a configuration diagram of a transistor according to Embodiment 2 of the invention.

### DETAILED DESCRIPTION OF THE PREFERRED EMBODIMENTS

### Embodiment 1.

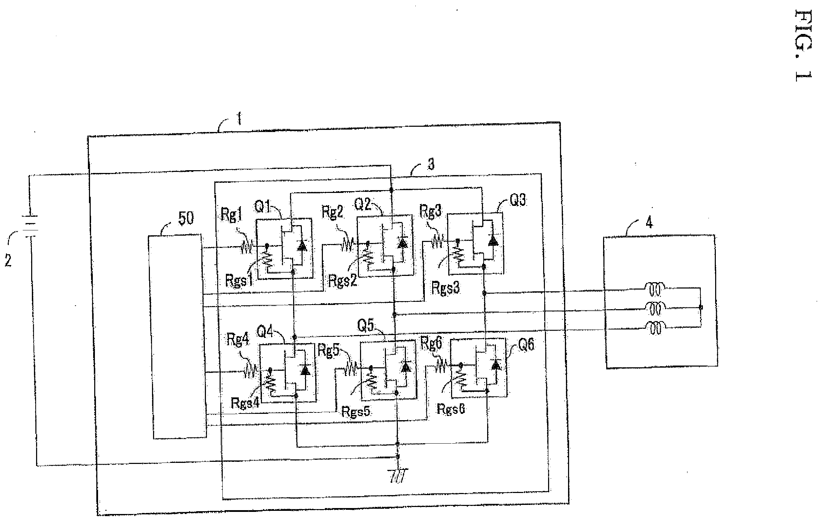

FIG. 1 is a circuit configuration diagram of a motor drive device according to Embodiment 1 of the present invention.

In FIG. 1, a motor drive circuit 3 includes semiconductor switching transistors (hereinafter simply referred to as transistors) Q1 to Q6, such as FETs (field effect transistors) or bipolar transistors, connected in a bridge configuration, and to which are connected a motor drive power supply 2 between the input terminals thereof and a motor 4 between the output terminals thereof.

A transistor drive circuit 50 sends a drive signal to the motor drive circuit 3 and takes on/off control of each of the transistors Q1 to Q6, thereby converting power supplied from the power supply 2 so as to drive the motor 4.

The drive signal output from the transistor drive circuit 50 is input to the gate (or base) of the transistors Q1 to Q6 via a wiring pattern and a bus bar of the substrate configured inside the motor drive device 1, gate resisters Rg1 to Rg6 provided, for controlling switching speed of the transistors and preventing oscillation thereof, junctions of the substrate with the bus bar and so forth.

The resisters between gate and source Rgs1 to Rgs6 are disposed and connected between the gate and source inside the respective transistors Q1 to Q6 in order to bring the transistors into an off-state without fail, when the transistor drive circuit 50 outputs an off-signal or even when an open-circuit or high-impedance failure occurs in the drive signal path.

In the conventional configuration in which the resisters between gate and source Rgs1 to Rgs6 are disposed and connected outside the transistors Q1 to Q6 respectively, when an open-circuit failure occurs at a location in the transistor side with respect to the junctions of the resisters between gate and source, the resisters between gate and source Rgs1 to Rgs6 are not connected with the transistors Q1 to Q6, so that the resisters cannot fulfill their intended function. Therefore, any transistor connected to the signal path in which the open-circuit failure occurs cannot be suddenly turned off, which may sometimes lead to transistor breakdown.

In contrast to this, in the motor drive device according to Embodiment 1 of the present invention, the resisters between gate and source Rgs1 to Rgs6 are disposed and connected inside the respective transistors Q1 to Q6; therefore, even when an open-circuit or high-impedance failure occurs in the drive signal path in which the drive signal from the transistor drive circuit 50 is input to the transistors Q1 to Q6, the resisters between gate and source Rgs1 to Rgs6 remain connected with the transistors Q1 to Q6 so as to properly fulfill their function, whereby the transistor connected to the signal path in which the failure occurs can be brought into the off-state without fail.

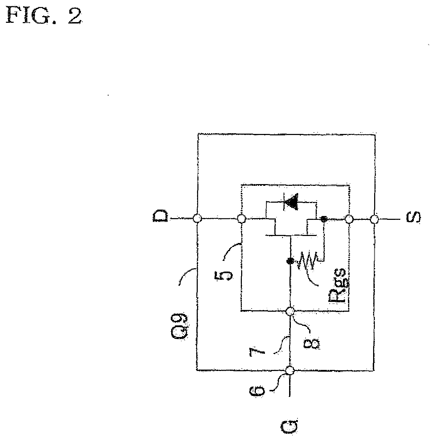

FIG. 2 is a connection diagram for explaining the internal configuration of the transistors described in FIG. 1 of Embodiment 1.

In FIG. 2, a transistor Q9 representing each of the transistors includes in its inside a semiconductor chip 5, and a bonding wire 7 connects a gate portion 8 on the semiconductor chip 5 with a gate terminal 6 of the transistor Q9.

Since a resister between gate and source Rgs is directly formed and disposed on the semiconductor chip 5, even when an open-circuit failure occurs at the gate terminal 6, the bonding wire 7 and the gate portion 8 on the semiconductor chip 5, which constitute a drive signal path inside the transistor Q9, the resister Rgs remains in a connected state on the semiconductor chip; therefore, the resister can effectively fulfill its function, so that the transistor Q9 can be brought into the off-state.

As described above, according to Embodiment 1 of the present invention, by configuring the transistor of the motor drive circuit with the resister between gate and source disposed inside the transistor, the transistor can be brought into the off-state without fail even when an open-circuit failure occurs in the drive signal path on the substrate. Moreover, there is no need for additionally providing extra parts outside, thereby enabling reduction in the number of parts and downsizing of the device.

Furthermore, the resister between gate and source is structurally formed and disposed on the semiconductor chip itself as well as inside the transistor, whereby the transistor can be brought into the off-state without fail even when an open-circuit failure occurs not only in the drive signal path on the substrate but also at the junctions inside the transistor.

### Embodiment 2.

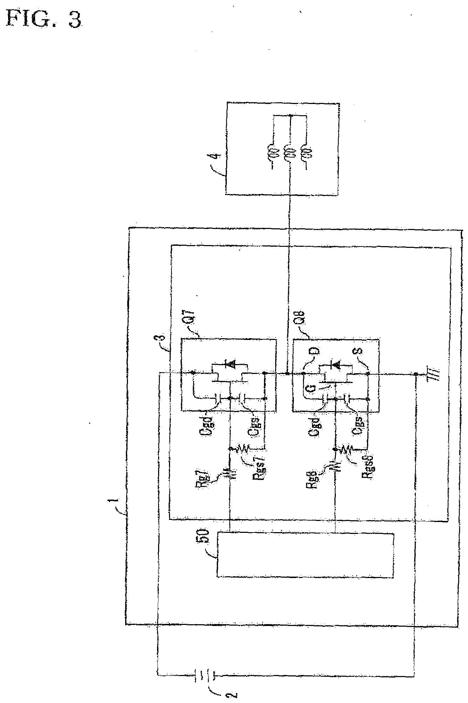

FIG. 3 is a system configuration diagram of a motor drive device according to Embodiment 2 of the present invention.

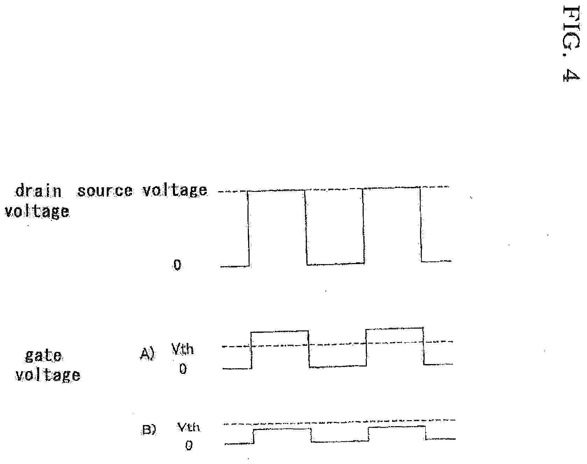

Here are described only transistors for one phase, out of those included in the motor drive circuit 3, necessary for explanation. Moreover, FIG. 4 is a voltage waveform diagram for supplementarily explaining details of Embodiment 2.

In FIG. 3, a parasitic capacitance Cgd attributable to semiconductor structure exists between the gate G and the drain D inside a transistor Q8. When an open-circuit failure occurs in a drive signal path connecting the transistor drive circuit 50 with the transistor Q8 and an upper side transistor Q7 connected with the transistor Q8 at the drain D side continues switching operation, switching pulses generated, by driving the transistor Q7, at the drain D side of the transistor Q8 are superimposed on the gate G side of the transistor Q8 through AC coupling by the parasitic capacitance between gate and drain Cgd. If the voltage between gate and source exceeds a threshold voltage Vth at which the transistor Q8 turns on, the transistor Q8 is brought into an on-state regardless of the drive signal path being open, thereby causing a short-circuit current and sometimes leading to transistor breakdown.

However, according to Embodiment 2 of the present invention, since a capacitor between gate and source Cgs is connected between the gate and source of the transistor Q8 as shown in FIG. 3, the pulse voltage superimposed on the gate G becomes a value of the switching pulse voltage at the drain D side being capacitively divided by the parasitic capacitance between gate and drain Cgd and the capacitance of the capacitor between gate and source Cgs.

Since the maximum pulse voltage generated at the drain D side of the transistor Q8 is equal to the voltage of the power supply 2, if the capacitor between gate and source Cgs is connected therebetween with its capacitance set to larger than a certain value, taking into consideration the maximum power supply voltage and the parasitic capacitance between gate and drain Cgd, the voltage between the gate and source of the transistor Q8 can be prevented from exceeding the threshold voltage Vth to turn on the transistor.

Explaining referring to FIG. 4, the gate voltage superimposed on the gate G of the transistor Q8, in relation to the drain voltage generated at the drain D side of the transistor Q8, exceeds the threshold voltage Vth as shown by A) in the figure, when the capacitor between gate and source Cgs is not connected or the capacitance thereof is not large enough; however when the capacitor between gate and source Cgs is connected with its capacitance set to larger than the certain value, the gate voltage does not exceed the threshold voltage Vth as shown by B), so that the transistor Q8 can be brought into the off-state.

In Embodiment 2, since the capacitor between gate and source Cgs is disposed and connected inside the transistor Q8, even when an open-circuit failure occurs in the signal path in which a drive signal from the transistor drive circuit 50 is input to the transistor Q8, the capacitor between gate and source Cgs remains connected with the transistor Q8; therefore, the capacitor effectively fulfills its function, so that the transistor Q8 connected to the path in which the failure occurs can be brought into the off-state.

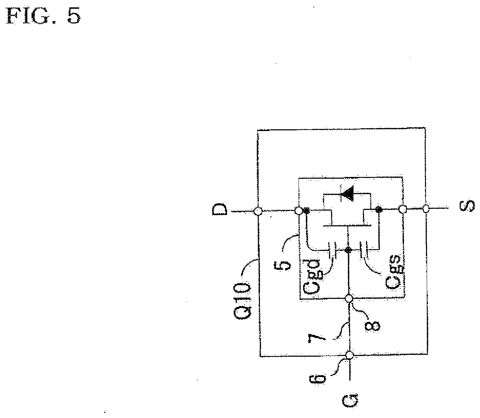

FIG. 5 is a connection diagram for explaining the internal configuration of the transistors described in FIG. 3 of Embodiment 2.

In FIG. 5, a transistor Q10 representing each of the transistors includes in its inside the semiconductor chip 5, and the bonding wire 7 connects the gate portion 8 on the semiconductor chip 5 with the gate terminal 6 of the transistor.

Since the capacitor between gate and source Cgs is directly formed and disposed on the semiconductor chip 5, even when an open-circuit failure occurs at the gate terminal 6, the bonding wire 7 and the gate portion 8 on the semiconductor chip 5, which constitute the drive signal path inside the transistor Q10, the capacitor between gate and source Cgs remains in the connected state on the semiconductor chip; therefore, the capacitor can effectively fulfill its function, so that the transistor Q10 can be brought into the off-state.

As described above, according to Embodiment 2 of the present invention, by configuring the transistor of the motor drive circuit with the capacitor between gate and source disposed inside the transistor, the transistor can be brought into the off-state without fail even when an open-circuit failure occurs, similarly to Embodiment1, in the drive signal path on the substrate. Moreover, there is no need for additionally providing extra parts outside, thereby enabling reduction in the number of parts and downsizing of the device.

Moreover, the capacitor between gate and source is structurally formed and disposed on the semiconductor chip itself as well as side the transistor, whereby the transistor can be brought into the off-state without fail even when an open-circuit failure occurs not only in the drive signal path on the substrate but also at the junctions inside the transistors.

### Embodiment 3.

Embodiment 1 and Embodiment 2 are combined with each other and implemented in the motor drive device 1 that uses the motor drive circuit 3 made up of the upper and lower arms (transistors) as shown in FIG. 1 and FIG. 3, which can prevent an excessive current caused by short-circuiting of both of the upper and lower arms due to an open-circuit failure in the drive signal path, whereby the motor drive device of a system and a power supply, a power line and a fuse connected to the device can be prevented from breaking down, disconnecting and heating up caused by the excessive current, thereby enhancing safety. Embodiment 4.

The whole of or a part of the circuit of the motor drive device 1 explained in Embodiment 1 to Embodiment 3 described above is sealed off with resin mold, thereby preventing wire disconnection and deterioration by the external environment. At least the resisters or the capacitors connected between the gate and source are sealed off with the resin mold, whereby reliability and durability of the device can be enhanced.

## Claims

1. A motor drive device (1), comprising:
a motor drive circuit (3) that includes switching transistors (Q1-Q6) connected in a bridge configuration and to which are connected a motor drive power supply (2) between input terminals thereof and a motor (4) between output terminals thereof; and
a transistor drive circuit (50) that supplies a drive signal to the switching transistors of the motor drive circuit and takes on/off control of the switching transistors; wherein
resisters (Rgs1-Rgs8) are connected between a gate and a source, or a base and an emitter, of each of the switching transistors (Q1-Q6) of the motor drive circuit so as to turn off the switching transistors when an open-circuit failure occurs in a drive signal path from the transistor drive circuit to the switching transistors,
**characterized by**:
the resisters (Rgs1-Rgs8) for bringing the respective switching transistors (Q1-Q6) into an off-state are disposed inside the respective switching transistors (Q1-Q6).

2. A motor drive device according to claim 1, wherein each of the switching transistors (Q9) constituting the motor drive circuit (3) is formed on their respective semiconductor chips (5), and the resisters (Rgs) are formed and disposed on the respective semiconductor chips (5) on which the switching transistors are formed.

3. A motor drive device (1), comprising:
a motor drive circuit (3) that includes switching transistors (Q7, Q8) connected in a bridge configuration and to which are connected a motor drive power supply (2) between input terminals thereof and a motor (4) between output terminals thereof; and
a transistor drive circuit (50) that supplies a drive signal to the switching transistors of the motor drive circuit and takes on/off control of the switching transistors; wherein
capacitors (Cgs) are connected between a gate and a source, or a base and an emitter, of each of the switching transistors (Q7, Q8) of the motor drive circuit so as to turn off the switching transistors when an open-circuit failure occurs in a drive signal path from the transistor drive circuit to the switching transistors,
**characterized by**:
the capacitors (Cgs) for bringing the respective switching transistors (Q7, Q8) into an off-state are disposed inside the respective switching transistors (Q7, Q8).

4. A motor drive device according to claim 3, wherein each of the switching transistors (Q10) constituting the motor drive circuit (3) is formed on their respective semiconductor chips (5) and the capacitors (Cgs) are formed and disposed on the respective semiconductor chips (5) on which the switching transistors are formed.

5. A motor drive device (1), comprising:
a motor drive circuit (3) that includes switching transistors (Q1-Q6) connected in a bridge configuration and to which are connected a motor drive power supply (2) between input terminals thereof and a motor (4) between output terminals thereof; and
a transistor drive circuit (50) that supplies a drive signal to the switching transistors of the motor drive circuit and takes on/off control of the switching transistors; wherein
resisters (Rgs) and capacitors (Cgs) are connected between a gate and a source, or a base and an emitter, of each of the switching transistors (Q1-Q6) of the motor drive circuit so as to turn off the switching transistors when an open-circuit failure occurs in a drive signal path from the transistor drive circuit to the switching transistors,
**characterized by**:
the resisters (Rgs) and the capacitors (Cgs) for bringing the respective switching transistors (Q1-Q6) into an off-state are disposed inside the respective switching transistors (Q1-Q6) .

6. A motor drive device according to claim 5, wherein each of the switching transistors (Q1-Q6) constituting the motor drive circuit (3) is formed on their respective semiconductor chips (5), and the resisters (Rgs) and the capacitors (Cgs) are formed and disposed on the respective semiconductor chips (5) on which the switching transistors are formed.

7. A motor drive device according to any one of claims 1 to 6, wherein the whole of or a part of the circuit of the motor drive device (1) is sealed off with resin mold.

## Patentansprüche

1. Eine Motorantriebsvorrichtung (1), bestehend aus:
eine Motorantriebsschaltung (3), die Schalttransistoren (Q1-Q6) enthält, die in einer Brückenkonfiguration verbunden sind und an die eine Motorantriebsstromversorgung (2) zwischen ihren Eingangsanschlüssen und ein Motor (4) zwischen ihren Ausgangsanschlüssen angeschlossen sind; und
eine Transistorantriebsschaltung (50), die ein Antriebssignal an die Schalttransistoren der Motorantriebsschaltung liefert und die Ein-/Aus-Steuerung der Schalttransistoren übernimmt; wobei
Widerstände (Rgs1-Rgs8) zwischen einem Gate und einer Quelle oder einer Basis und einem Emitter jedes der Schalttransistoren (Q1-Q6) der Motorantriebsschaltung geschaltet sind, um die Schalttransistoren abzuschalten, wenn ein Fehler im offenen Stromkreis in einem Antriebsignalpfad von der Transistorantriebsschaltung zu den Schalttransistoren auftritt,
**gekennzeichnet dadurch, dass**:
die Widerstände (Rgs1-Rgs8) zum Versetzen der jeweiligen Schalttransistoren (Q1-Q6) in einen Aus-Zustand innerhalb der jeweiligen Schalttransistoren (Q1-Q6) angeordnet sind.

2. Eine Motorantriebsvorrichtung nach Anspruch 1, wobei jeder der Schalttransistoren (Q9), die die Motorantriebsschaltung (3) bilden, auf ihren jeweiligen Halbleiterchips (5) ausgebildet ist, und die Widerstände (Rgs) auf den jeweiligen Halbleiterchips (5), auf denen die Schalttransistoren ausgebildet sind, ausgebildet und angeordnet sind.

3. Eine Motorantriebsvorrichtung (1), umfassend:
eine Motorantriebsschaltung (3), die Schalttransistoren (Q7, Q8) enthält, die in einer Brückenkonfiguration verbunden sind und an die eine Motorantriebsstromversorgung (2) zwischen ihren Eingangsanschlüssen und ein Motor (4) zwischen ihren Ausgangsanschlüssen angeschlossen sind; und
eine Transistorantriebsschaltung (50), die ein Antriebssignal an die Schalttransistoren der Motorantriebsschaltung liefert und die Ein-/Aus-Steuerung der Schalttransistoren übernimmt; wobei
Kondensatoren (Cgs) zwischen einem Gate und einer Quelle oder einer Basis und einem Emitter jedes der Schalttransistoren (Q7, Q8) der Motorantriebsschaltung geschaltet sind, um die Schalttransistoren abzuschalten, wenn ein Leerlauffehler in einem Antriebssignalpfad von der Transistorantriebsschaltung zu den Schalttransistoren auftritt,
**gekennzeichnet dadurch, dass**:
die Kondensatoren (Cgs) zum Versetzen der jeweiligen Schalttransistoren (Q7, Q8) in einen Aus-Zustand innerhalb der jeweiligen Schalttransistoren (Q7, Q8) angeordnet sind.

4. Eine Motoransteuesvorrichtung nach Anspruch 3, wobei jeder der Schalttransistoren (Q10), die die Motorantriebsschaltung (3) bilden, auf ihren jeweiligen Halbleiterchips (5) ausgebildet ist und die Kondensatoren (Cgs) auf den jeweiligen Halbleiterchips (5), auf denen die Schalttransistoren ausgebildet sind, ausgebildet und angeordnet sind.

5. Eine Motorantriebsvorrichtung (1), umfassend:
eine Motorantriebsschaltung (3), die Schalttransistoren (Q1-Q6) enthält, die in einer Brückenkonfiguration verbunden sind und an die eine Motorantriebsstromversorgung (2) zwischen ihren Eingangsanschlüssen und ein Motor (4) zwischen ihren Ausgangsanschlüssen angeschlossen sind; und
eine Transistorantriebsschaltung (50), die ein Antriebssignal an die Schalttransistoren der Motorantriebsschaltung liefert und die Ein/Aus-Steuerung der Schalttransistoren übernimmt; wobei
Widerstände (Rgs) und Kondensatoren (Cgs) zwischen einem Gate und einer Quelle oder einer Basis und einem Emitter jedes der Schalttransistoren (Q1-Q6) der Motoransteuerschaltung geschaltet sind, um die Schalttransistoren abzuschalten, wenn ein Leerlauffehler in einem Ansteuersignalpfad von der Transistoransteuerschaltung zu den Schalttransistoren auftritt,
**gekennzeichnet dadurch, dass**:
die Widerstände (Rgs) und die Kondensatoren (Cgs) zum Versetzen der jeweiligen Schalttransistoren (Q1-Q6) in einen Aus-Zustand innerhalb der jeweiligen Schalttransistoren (Q1-Q6) angeordnet sind.

6. Eine Motorantriebsvorrichtung nach Anspruch 5, wobei jeder der Schalttransistoren (Q1-Q6), die die Motorantriebsschaltung (3) bilden, auf ihren jeweiligen Halbleiterchips (5) ausgebildet ist, und die Widerstände (Rgs) und die Kondensatoren (Cgs) auf den jeweiligen Halbleiterchips (5), auf denen die Schalttransistoren ausgebildet sind, ausgebildet und angeordnet sind.

7. Eine Motorantriebsvorrichtung nach einem der Ansprüche 1 bis 6, wobei der gesamte oder ein Teil des Schaltkreises der Motorantriebsvorrichtung (1) mit einer Harzform versiegelt ist.

## Revendications

1. Dispositif d'entraînement de moteur (1), comprenant :
un circuit d'entraînement de moteur (3) qui inclut des transistors de commutation (Q1-Q6) connectés dans une configuration en pont et auquel sont connectés une alimentation électrique d'entraînement de moteur (2) entre ses bornes d'entrée et un moteur (4) entre ses bornes de sortie ; et
un circuit d'entraînement de transistors (50) qui fournit un signal d'entraînement aux transistors de commutation du circuit d'entraînement de moteur et active/désactive une commande des transistors de commutation ; dans lequel
des résistances (Rgs1-Rgs8) sont connectées entre une grille et une source, ou une base et un émetteur, de chacun des transistors de commutation (Q1-Q6) du circuit d'entraînement de moteur de manière à désactiver les transistors de commutation lorsqu'une défaillance de circuit ouvert se produit dans un trajet de signal d'entraînement du circuit d'entraînement de transistors aux transistors de commutation,
**caractérisé en ce que** :
les résistances (Rgs1-Rgs8) pour amener les transistors de commutation (Q1-Q6) respectifs dans un état désactivé sont disposées à l'intérieur des transistors de commutation (Q1-Q6) respectifs.

2. Dispositif d'entraînement de moteur selon la revendication 1, dans lequel chacun des transistors de commutation (Q9) constituant le circuit d'entraînement de moteur (3) est formé sur leurs puces semi-conductrices (5) respectives, et les résistances (Rgs) sont formées et disposées sur les puces semi-conductrices (5) respectives sur lesquelles les transistors de commutation sont formés.

3. Dispositif d'entraînement de moteur (1), comprenant :
un circuit d'entraînement de moteur (3) qui inclut des transistors de commutation (Q7, Q8) connectés dans une configuration en pont et auquel sont connectés une alimentation électrique d'entraînement de moteur (2) entre ses bornes d'entrée et un moteur (4) entre ses bornes de sortie ; et
un circuit d'entraînement de transistors (50) qui fournit un signal d'entraînement aux transistors de commutation du circuit d'entraînement de moteur et active/désactive une commande des transistors de commutation ; dans lequel
des condensateurs (Cgs) sont connectés entre une grille et une source, ou une base et un émetteur, de chacun des transistors de commutation (Q7, Q8) du circuit d'entraînement de moteur de manière à désactiver les transistors de commutation lorsqu'une défaillance de circuit ouvert se produit dans un trajet de signal d'entraînement du circuit d'entraînement de transistors aux transistors de commutation,
**caractérisé en ce que** :
les condensateurs (Cgs) pour amener les transistors de commutation (Q7, Q8) respectifs dans un état désactivé sont disposés à l'intérieur des transistors de commutation (Q7, Q8) respectifs.

4. Dispositif d'entraînement de moteur selon la revendication 3, dans lequel chacun des transistors de commutation (Q10) constituant le circuit d'entraînement de moteur (3) est formé sur leurs puces semi-conductrices (5) respectives et les condensateurs (Cgs) sont formés et disposés sur les puces semi-conductrices (5) respectives sur lesquelles les transistors de commutation sont formés.

5. Dispositif d'entraînement de moteur (1), comprenant :
un circuit d'entraînement de moteur (3) qui inclut des transistors de commutation (Q1-Q6) connectés dans une configuration en pont et auquel sont connectés une alimentation électrique d'entraînement de moteur (2) entre ses bornes d'entrée et un moteur (4) entre ses bornes de sortie ; et
un circuit d'entraînement de transistors (50) qui fournit un signal d'entraînement aux transistors de commutation du circuit d'entraînement de moteur et active/désactive une commande des transistors de commutation ; dans lequel
des résistances (Rgs) et des condensateurs (Cgs) sont connectés entre une grille et une source, ou une base et un émetteur, de chacun des transistors de commutation (Q1-Q6) du circuit d'entraînement de moteur de manière à désactiver les transistors de commutation lorsqu'une défaillance de circuit ouvert se produit dans un trajet de signal d'entraînement du circuit d'entraînement de transistors aux transistors de commutation,
**caractérisé en ce que** :
les résistances (Rgs) et les condensateurs (Cgs) pour amener les transistors de commutation (Q1-Q6) respectifs dans un état désactivé sont disposés à l'intérieur des transistors de commutation (Q1-Q6) respectifs.

6. Dispositif d'entraînement de moteur selon la revendication 5, dans lequel chacun des transistors de commutation (Q1-Q6) constituant le circuit d'entraînement de moteur (3) est formé sur leurs puces semi-conductrices (5) respectives, et les résistances (Rgs) et les condensateurs (Cgs) sont formés et disposés sur les puces semi-conductrices (5) respectives sur lesquelles les transistors de commutation sont formés.

7. Dispositif d'entraînement de moteur selon l'une quelconque des revendications 1 à 6, dans lequel la totalité ou une partie du circuit du dispositif d'entraînement de moteur (1) est scellée avec un moulage en résine.
